# EUROPEAN PATENT APPLICATION

(11) **EP 1 381 164 A1**
(43) Date of publication of application: **14.01.2004**
(21) Application number: 03015908.1
(22) Date of filing: 11.07.2003
(51) Int. Cl.: H04B 1/38, B60R 11/02

(54) **A system for the management of radio communications in a motor vehicle, including a plug-in electronic module for receiving and transmitting radio signals**

(30) Priority: 12.07.2002 IT TO20020603
(71) Applicant: IXFIN MAGNETI MARELLI SISTEMI ELETTRONICI S.p.A., 20011 Corbetta (Milano) (IT)
(72) Inventor: Borin, Andrea, 29015 Castel san Giovanni (Piacenza) (IT)
(74) Representative: Deambrogi, Edgardo

(57) **Abstract**

A system is described for the management of radio communications in a motor vehicle, including a plug-in electronic module (26) with at least one circuit card (32) for the reception and transmission of analog/digital radio communications according to a predetermined protocol (GSM, GPRS, UMTS, GPS, Bluetooth); and an on-board control unit (10) with a processing unit and a power supply circuit, in which the said electronic module (26) can be plugged removably into a circuit board (12) carrying the on-board control unit (10) and having at least one corresponding socket (24).

The module (26) is arranged to receive electric power from the supply circuit of the control unit (10) and to exchange data with the associated processing unit.

The control unit (10) is arranged to recognize that the electronic module (26) has been plugged in and to configure the processing unit according to the plug and play technology.

## Description

The present invention relates in general to an electronic system for management of the reception and transmission of analogue and digital radio signals on board a motor vehicle.

The growing demand for electronic systems which make it more comfortable simply to be in or to drive a motor vehicle has led to the development and introduction of advanced connectivity systems providing radio connection between separate on-board devices and between the vehicle and the outside world.

It is sufficient to think in this context of recent electronic developments which have led to integrated car radio and telephone systems being installed in vehicles, or of on-going research into providing vehicles with communication systems offering radio location, exchange of traffic information and even driving aids.

At the moment, these functions are handled by electronic control modules permanently integrated into the electronic cards of control units distributed into the structure of the vehicle or - in the case of systems for communication between separate on-board devices - provided in the form of autonomous circuit boards.

When adapting a system which does not offer such functions to a system which does include them, it was necessary until now to replace the existing control unit with a different unit integrating a control module for operating the required functions.

The disadvantage of this is that it is complicated to replace the control unit and this increases the cost of the vehicle.

The object of the present invention is to increase the connecting functions in a vehicle and to make them more flexible, thus making it possible to reconfigure them simply, rapidly and economically, without the need to replace existing system components.

This object is achieved according to the present invention by providing a system for the management of radio communications having the characteristics claimed in Claim 1.

According to the invention, the radio connectivity functions in the vehicle are concentrated in one plug-in electronic module independent from the arrangement of the on-board electronic control units.

The module of the invention can conveniently be plugged, removably, into a control unit in a basic configuration provided, during its manufacture, with a socket for receiving such a module, thereby constituting a control system offering every necessary function.

This makes it possible to introduce as options various analogue and digital radio reception and transmission protocols and methods, updating and/or increasing at any time the functions supported, thanks to the flexibility provided for installing new functions and services using innovative radio technology. The solution according to the invention thus offers the advantage of increasing the radio connectivity of automotive systems with portable objects (radiotelephones, for example), telecommunications infrastructure (telephone networks or radio broadcast, for example) or radio-communications satellites.

Further characteristics and advantages of the invention will be explained in more detail in the following detailed description of one embodiment thereof, provided purely by way of non-limitative example, with reference to the appended drawings, in which:

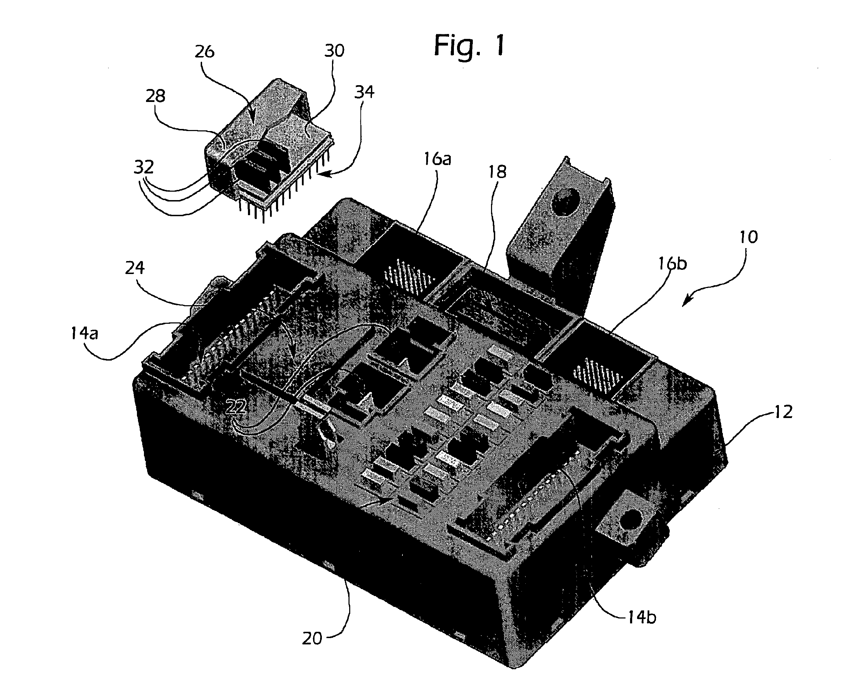

Figure 1 is an overall perspective view of an on-board electronic unit arranged to receive a plug-in module and of such a separate plug-in module, together forming the system constituting the subject of the invention; and

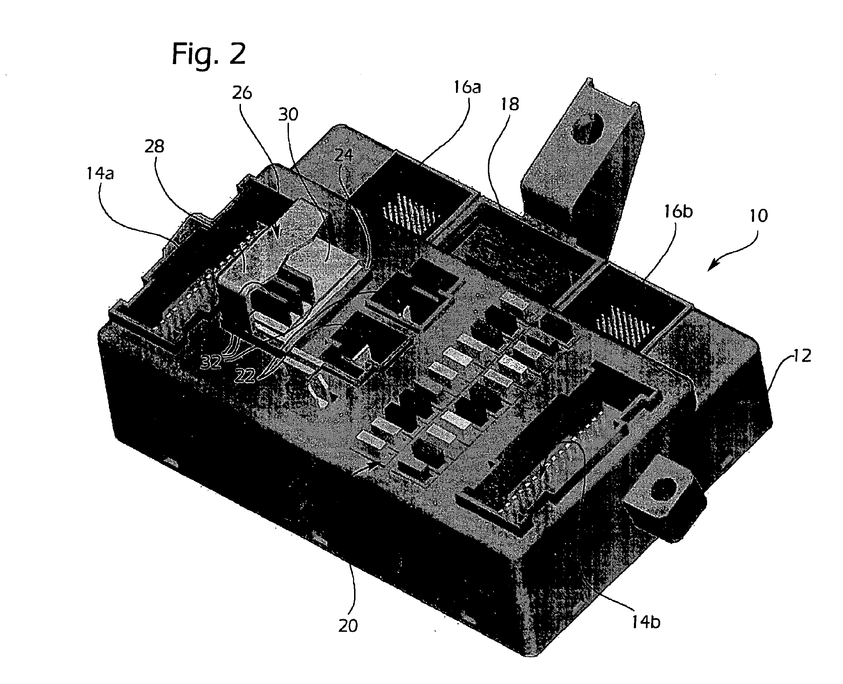

Figure 2 is an overall perspective view of the card of Figure 1 in its assembled configuration.

An electronic control unit intended to be installed on-board a vehicle and carrying a plurality of circuits for the management, for example, of functions relating to the vehicle body and the passenger compartment, is generally indicated 10 and includes a circuit board 12.

The board 12 has a series of connectors 14a, 14b, 16a, 16b, 18 which make it possible to interconnect the associated control circuits on each respective card, with respective lines connecting them to on-board devices. A plurality of protection fuses 20 can be seen and a pair of relay sockets 22.

The unit 10 also has a socket or housing 24 for receiving an electronic plug-in module 26 according to the invention for the management of radio communication functions.

The module 26 is a module for the reception and transmission of both analogue and digital radio signals, having structural characteristics typical of any relay used in the automobile industry and differing from such a known relay only by the number and dimensions of the connector terminals.

Arranged in a case 28, it includes a main interconnection card 30 and a plurality of dedicated printed circuit cards 32 connected to the interconnection card 30 in a minirack arrangement. The dedicated cards 32 incorporate respective hybrid circuits for controlling radio communications according to selected technological methods, in a manner which is known per se.

A series of connector terminals 34 crosses case 28 on the base surface in the configuration of the drawing. The module 26 can be connected to the circuit board of the control unit by the said terminals in order both to be supplied with electrical power and to exchange data according to known serial or parallel communication protocols.

It is convenient if a processing module associated with the control unit has in its memory a programme for automatically recognizing the module 26 when it is inserted into the housing 24 (plug and play technology), thereby ensuring that the system is easily re-configured and that on-board functions can be updated simply.

The module 26 is plugged into the control unit board in a manner similar to that used to plug relays into electronic or electromechanical modules, except for the connection configuration which requires a greater number of paths than that of a routine relay. The plug-in module can also have mechanical means for snap engagement and retention in the housing 24.

In the dedicated cards 32, the module integrates one or more electronic circuits dedicated to the reception and transmission of radio channels according to various methods. In an embodiment which is currently preferred, the receipt and transmission module 26 is arranged to integrate GPS, GSM/GPRS/UMTS and Bluetooth digital radio communications technology.

The GPS connection is used as navigation assistance and in order to pinpoint the vehicle if it is stolen.

The GSM/GPRS/UMTS connection makes it possible, for example, to provide the system with an on-board telephone which could be used for emergency calls without the need to insert a SIM card or in association with a driver/passenger's private telephone by exchanging identification data on the Bluetooth connection.

Lastly, the Bluetooth technology makes it possible to connect portable devices (PDA, radiotelephones, diagnostic testers and others) thereby making these an integral part of the vehicle on-board communications network, sharing the man-machine interface already installed in the vehicle. From the outside, the aforementioned portable devices can be used to control security and diagnostic functions or to check the condition of the vehicle (lights, faults, fuel level, etc.) using the same Bluetooth communications channel so long as this function is provided by the technology in use.

Naturally, the principle of the invention remaining unchanged, embodiments and manufacturing details may vary widely from those described and illustrated here purely by way of non-limitative example, without departing thereby from the scope of the invention, as defined in the appended Claims.

## Claims

1. A system for the management of radio communications in a motor vehicle, **characterised in that** it includes:
a plug-in electronic module (26) which includes at least one circuit card (32) for the reception and transmission of analogue and digital radio communications according to a predetermined communications protocol; and
an on-board control unit (10) with processing circuit means and power supply circuit means,
the said electronic module (26) being able to be plugged, removably into a circuit board (12) carrying the said on-board control unit (10) and having at least one socket (24) for housing the said module (26), thereby receiving electrical power from the said supply means and exchanging data with the said processing means of the control unit (10).

2. A system according to Claim 1, **characterised in that** the said control unit (10) has means for recognizing that a said electronic module (26) has been plugged in and for configuring the said processing means for controlling communications with the said at least one circuit card (32) associated with the module (26).

3. A system according to Claims 1 or 2, **characterised in that** the said electronic module (26) includes, within a protection case (28), an interconnection card (30) bearing a connector member with a plurality of terminals (34) and arranged to receive, in a removable coupling configuration, a plurality of circuit cards (32) for the reception and transmission of radio communications according to respective communications protocols.

4. A system according to Claim 3, **characterised in that** the case (28) of the said module (26) has retaining means for mechanically coupling the said module (26) to the said circuit board (12) carrying the control unit (10) and retaining it in the respective socket (24).

5. A system according to any preceding Claim, **characterised in that** the exchange of data between the said plug-in module (26) and the processing means of the control unit (10) takes place by means of a serial communication line.

6. A system according to any Claim from 1 to 4, **characterised in that** the exchange of data between the said plug-in module (26) and the processing means of the control unit (10) takes place by means of a parallel communication line.

7. A system according to any preceding Claim, **characterised in that** the said plug-in electronic module (26) includes at least one circuit card (32) for the reception and transmission of radio communications according to GPS technology.

8. A system according to any preceding Claim, **characterised in that** the said plug-in electronic module (26) includes at least one circuit card (32) for the reception and transmission of radio communications according to GSM, GPRS, UMTS technology.

9. A system according to any preceding Claim, **characterised in that** the said plug-in electronic module (26) includes at least one circuit card (32) for the reception and transmission of radio communications according to Bluetooth technology.
